Europäisches Patentamt

European Patent Office

Office européen des brevets

(19)

(11) **EP 0 636 703 B1**

(12) **EUROPÄISCHE PATENTSCHRIFT**

(45) Veröffentlichungstag und Bekanntmachung des Hinweises auf die Patenterteilung:
**09.09.1998 Patentblatt 1998/37**

(51) Int Cl.$^6$: **C23C 14/34**

(21) Anmeldenummer: **94109667.9**

(22) Anmeldetag: **22.06.1994**

(54) **Verfahren zur Abscheidung einer Schicht auf einer Substratscheibe durch Sputtern durch Verwendung eines Kollimators**

Method for deposition of a layer on a substrate-disk by sputtering using a collimator

Procédé pour le dépôt d'une couche sur un substrat en forme de disque par pulvérisation avec un collimateur

(84) Benannte Vertragsstaaten:
**DE FR GB IT**

(30) Priorität: **26.07.1993 DE 4325051**

(43) Veröffentlichungstag der Anmeldung:
**01.02.1995 Patentblatt 1995/05**

(73) Patentinhaber: **SIEMENS AKTIENGESELLSCHAFT**
**80333 München (DE)**

(72) Erfinder:
- **Werner, Christoph, Dr.**
  **D-85665 Moosach (DE)**
- **Kersch, Alfred, Dr.**
  **D-81669 München (DE)**

(56) Entgegenhaltungen:
**EP-A- 0 509 305**   **DD-A- 285 897**
**US-A- 5 223 108**

**Beschreibung**

Sputterprozesse werden in der Halbleitertechnologie vielfach zum Abscheiden von Schichten aus verschiedenen Materialien verwendet. Dazu wird in einem Sputterreaktor zwischen zwei Elektroden ein Plasma gezündet. Auf der Kathode wird ein Sputtertarget angeordnet, auf der Anode eine Substratscheibe, auf der die Schicht abgeschieden werden soll. Positiv geladene Ionen eines Schutzgases, zum Beispiel Argon werden auf das Target zubeschleunigt und schlagen bei Auftreffen auf das Target aus diesem einzelne Atome oder Moleküle heraus. Das Target besteht aus einem zur Schichtabscheidung benötigten Material. Die herausgeschlagenen Teilchen bilden einen Teilchenstrom, der an der Targetoberfläche eine Verteilung in alle Richtungen aufweist. Man unterscheidet daher bei Sputterprozessen zwei Komponenten von gesputterten Teilchenströmen: eine vertikale Komponente, die senkrecht auf die Substratscheibe auftrifft, und eine laterale Komponente, die mit einem gewissen Winkel zur Oberfläche der Substratscheibe auftrifft.

Bei Abscheidung einer Schicht auf einer Substratscheibe mit im wesentlichen planarer Oberfläche tragen beide Komponenten des Teilchenstroms zur Schichterzeugung bei. Weist jedoch die Oberfläche des Substrats Strukturen auf mit Aspektverhältnissen von 1 und kleiner, trägt im wesentlichen nur die vertikale Stromkomponente zur Schichterzeugung bei. Unter Aspektverhältnis versteht man den Quotienten Durchmesser zur Tiefe. Aspektverhältnisse von 1 und kleiner treten insbesondere bei der Auffüllung von Kontaktlöchern mit Metallisierungsschichten auf. Die laterale Stromkomponente prallt auf die Seitenwände der Strukturen und bedeckt praktisch nur diese Seitenwände. Dadurch wird die Auffüllung der Strukturen, zum Beispiel Kontakt löcher, erschwert.

Aus Ron Iscoff, Semiconductor International, August 1992, p 43, ist bekannt, durch Verwendung eines Kollimators zwischen der Substratscheibe und dem Target die laterale Komponente vor dem Auftreffen auf der Substratscheibe abzufangen (Ein solches Verfahren ist auch aus EP-A-509 305 bekannt). Dadurch wird ein Bedecken der Seitenwände zum Beispiel von Kontakt löchern vermieden, so daß die Qualität der Kontaktlochauffüllung verbessert wird. Dieses erfolgt jedoch auf Kosten der Höhe der Abscheiderate. Außerdem wird bei Verwendung eines Kollimators in einem gängigen Sputterreaktor ohne zusätzliche Maßnahme die Abscheiderate sehr unhomogen über die Substratscheibe verteilt. Das liegt daran, daß gängige Reaktoren dahingehend optimiert sind, daß die Summe aus lateraler und vertikaler Stromkomponente homogen ist. Die vertikale Komponente für sich wird nicht optimiert.

Eine Optimierung der vertikalen Komponente kann durch Veränderung des Magnetfelds am Target erreicht werden. Dadurch wird bewirkt, daß die vertikale Stromkomponente für sich allein genommen eine homogene Verteilung aufweist, während die laterale Stromkomponente eine relativ inhomogene Verteilung aufweist. Die laterale Stromkomponente wird durch den Kollimator aufgefangen, so daß die Inhomogenität die Abscheidung nicht beeinträchtigt.

Da die Korrelation zwischen der Homogenität der Abscheiderate und dem Magnetfeld sehr indirekt ist, erfordert eine Optimierung der Verteilung der vertikalen Stromkomponente auf diese Weise langwierige Versuchsreihen. Außerdem ist eine Modifikation des Magnetfeldes in der Regel nur durch einen Eingriff des Herstellers des Reaktors möglich. Das führt zu einer zusätzlichen Verzögerung in der Prozeßentwicklung. Schließlich führt das Abfangen der lateralen Komponente im Kollimator zu einer Alterung des Kollimators. Die laterale Stromkomponente bewirkt auf den Seitenwänden der Löcher des Kollimators eine Schichtabscheidung, die zu einem allmählichen Zusputtern der Kollimatorlöcher führt. Da die laterale Stromkomponente wegen der Optimierung der vertikalen Stromkomponente inhomogen über die Kollimatorausdehnung ist, läßt sich dieser Alterungseffekt nicht kompensieren.

Der Erfindung liegt das Problem zugrunde, ein Verfahren zur Abscheidung einer Schicht auf einer Substratscheibe mit Hilfe eines Sputterprozesses anzugeben, in dem eine gleichmäßige Schichtabscheidung auch bei inhomogener vertikaler Stromkomponente erreicht wird. Das Verfahren soll insbesondere geeignet sein zum Auffüllen von Strukturen wie Kontakt löchern mit Aspektverhältnissen kleiner gleich 1.

Diese Aufgabe wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren wird in einem Sputterprozeß ein Kollimator verwendet, der laterale Komponenten des Teilchenstroms ausblendet. Der Kollimator ist mit zylindrischen Löchern versehen, deren Zylinderachse im wesentlichen senkrecht zur Oberfläche der Substratscheibe ausgerichtet ist. Der Durchmesser der Löcher des Kollimators ist für verschiedene Löcher unterschiedlich. Die Verteilung der Lochradien wird so gewählt, daß in Bereichen höherer vertikaler Stromkomponenten die Lochradien kleiner sind als in Bereichen mit kleinerer radikaler Stromkomponenten. Dadurch wird die auf der Substratscheibe aufkommende Abscheiderate homogenisiert.

Bei vielen gebräuchlichen Sputterreaktoren gibt es auf dem Target einen Ort außerhalb des Mittelpunkts des Targets, an dem eine maximale Sputterrate auftritt. In derartigen Reaktoren ist es vorteilhaft, die Lochradien vom Mittelpunkt des Reaktors bis zum Ort maximaler Sputterraten am Target stetig abnehmen zu lassen und von diesem Ort bis zu einem dem Scheibenrand entsprechenden Abstand vom Mittelpunkt zunehmen zu lassen und außerhalb des Scheibenrands konstant zu halten.

Um Probleme bei der Auffüllung kleiner Strukturen, zum Beispiel Kontaktlöcher, zu vermeiden, ist es vorteilhaft, den minimalen Lochradius so zu wählen, daß das Aspektverhältnis des Kollimators bei minimalem Lochradius gleich dem Aspektverhältnis derjenigen Strukturen in der Oberfläche der Substratscheibe mit dem kleinsten Durchmesser ist.

Es liegt im Rahmen der Erfindung, die Sputterrate in dem Reaktor durch Anlegen eines Magnetfeldes so zu beeinflussen, daß die laterale Stromdichte homogen eingestellt wird. Dadurch kommt es über die Fläche des Kollimators zu gleichmäßigen Abscheidungen und damit zu einem homogenen Alterungseffekt, der global durch die Sputterzeit kompensiert werden kann.

Mit dem erfindungsgemäßen Verfahren kann die Abscheiderate in kürzerer Zeit und ohne zeitaufwendige Rückkopplung mit dem Equipmenthersteller optimiert werden.

Ferner kann das erfindungsgemäße Verfahren verwendet werden um nach einer groben Voreinstellung des Magnetfelds beim Equipmenthersteller eine Feinjustierung bei der Prozeßoptimierung vorzunehmen.

Zusätzlich zu der Veränderung der Lochradien liegt es im Rahmen der Erfindung den Abstand zwischen benachbarten Löchern zu variieren, um so die Größe des durchgelassenen Teilchenstroms zu verändern. Ein Teil der vertikalen Stromkomponente wird dabei durch Auftreffen auf massives Kollimatormaterial unterdrückt.

In dieser Variante des verwendeten Kollimators kann zusätzlich zwischen benachbarten Löchern ein Abschattungssteg vorgesehen werden. Dadurch wird das Aspektverhältnis des Kollimators künstlich verkleinert. Ein Teil der lateralen Stromkomponente, der unter einem genügend flachen Winkel einfällt, wird auf den Abschattungsstegen abgeschieden. Dieser Anteil der lateralen Komponente gelangt nicht in die Seitenwände der Kollimatorlöcher und trägt daher nicht zum Alterungseffekt bei. Auf diese Weise wird die Abnahme des Lochradius durch Abscheiden der lateralen Stromkomponente verlangsamt.

Im folgenden wird die Erfindung anhand der Ausführungsbeispiele und der Figuren näher erläutert.

Figur 1    zeigt einen Sputterreaktor mit einem Target, einer Substratscheibe und mit einem Kollimator mit Löchern mit unterschiedlichen Lochradien.

Figur 2    zeigt das Ergebnis von Simulationsrechnungen für die Abscheiderate in einem Sputterprozeß bei einer vorgegebenen Lochradienverteilung.

Figur 3    zeigt eine bevorzugte Lochradienverteilung für das erfindungsgemäße Verfahren.

Figur 4    zeigt einen Schnitt durch einen Kollimator mit Löchern mit unterschiedlichen Lochradien und unterschiedlichen Abständen und mit Abschattungsstegen.

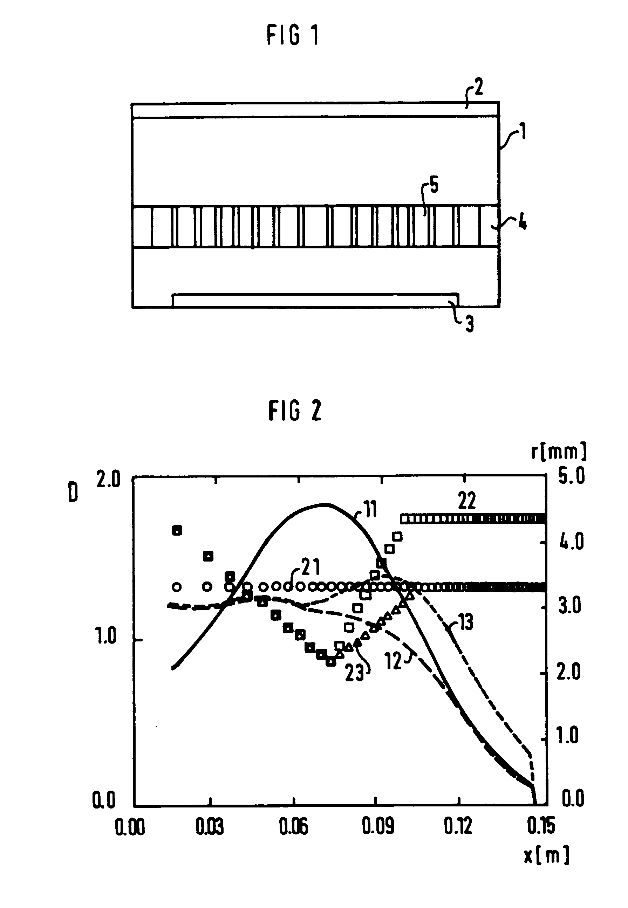

Figur 1 zeigt einen Schnitt durch einen Sputterreaktor 1. Details des Sputterreaktors 1 wie elektrische Anschlüsse, Gaszuführungen, Pumpstutzen oder Spulen zur Erzeugung eines magnetischen Feldes sind der Übersichtlichkeit halber weggelassen. In dem Sputterreaktor 1 ist ein Sputtertarget 2 angeordnet. Dem Sputtertarget 2 gegenüber ist eine Substratscheibe 3 so angeardnet, daß der Scheibenmittelpunkt mit dem Mittelpunkt des Sputterreaktors 1 zusammenfällt. Die Substratscheibe 3 ist zum Beispiel eine Siliziumscheibe, in der eine mikroelektronische Schaltung realisiert ist und deren Oberfläche mit einer Passivierungsschicht versehen ist, in der Kontaktlöcher, die in dem Sputterverfahren gefüllt werden sollen, geöffnet sind.

Zwischen dem Sputtertarget 2 und der Substratscheibe 3 ist ein Kollimator 4 angeordnet. Der Kollimator weist eine Vielzahl von Löchern 5 auf, die parallel zur Oberfläche der Substratscheibe 3 einen im wesentlichen kreisförmigen Querschnitt aufweisen. Im übrigen sind die Löcher 5 zylinderförmig. Die Radien der Löcher 5 sind über den Kollimator 4 verteilt unterschiedlich. Während in der Mitte des Sputterreaktors 1 die Lochradien verhältnismäßig groß sind, werden sie bei etwa zwei Drittel des Scheibenradius der Substratscheibe 3 ihren kleinsten Wert erreichen.

Der optimale Lochradius kann empirisch durch Bewertung der abgeschiedenen Schicht auf die Substratscheibe 3 bestimmt werden.

Alternativ wird die Verteilung der Lochradien mit Hilfe eines Simulationsprogrammes wie es zum Beispiel aus A. Kersch et al., IEDM 92, paper 7.6, San Francisco, 1992, bekannt ist, iterativ berechnet.

Figur 2 zeigt Simulationsrechnungen der Abscheiderate D als Funktion des Abstands von der Reaktormitte x. Die Abscheiderate D ist dabei auf eine vorgegebene Abscheiderate normiert. Die Abscheiderate D ist jeweils für eine vorgegebene Verteilung von Lochradien berechnet. In der Kurve 11 ist die Abscheiderate für den Fall berechnet, daß die Lochradien die in der Kurve 21 angegebene konstante Verteilung aufweisen. Die Kurve 12 ergibt sich bei Vorgabe einer Lochradienverteilung entsprechend Kurve 22. Die Abscheiderate entsprechend Kurve 13 ergibt sich bei Vorgabe einer Lochradienverteilung entsprechend Kurve 23. Auf der rechten Achse des Diagramms ist der Lochradius r aufgetragen.

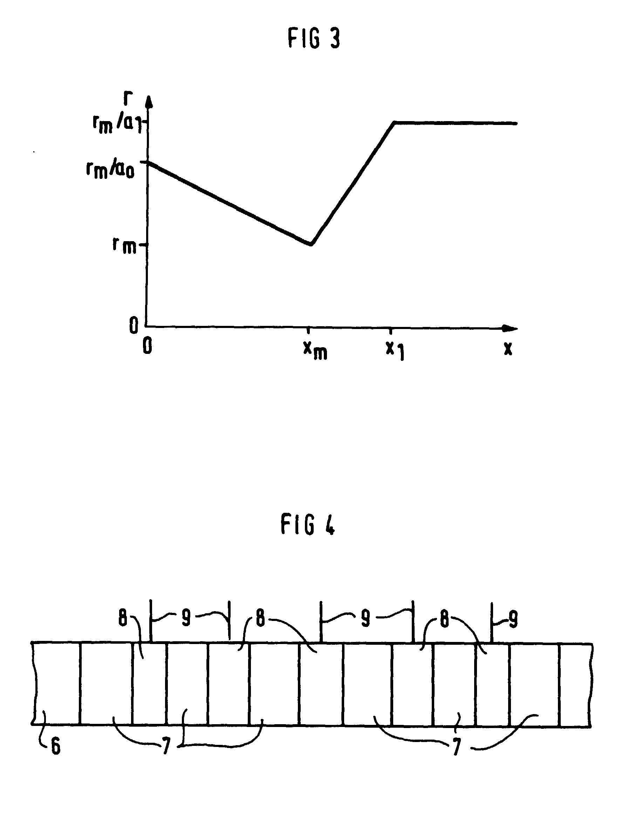

Figur 3 zeigt eine Lochradienverteilung als Funktion des Abstands x von der Reaktormitte, mit der unter Verwendung von empirischen Daten relativ schnell eine homogene Abscheiderate erzielt werden kann. Die Verteilung ist eine stückweise lineare Funktion für die gilt:

$$r(x) = \frac{r_m - r_m/a_o}{x_m} \cdot x + \frac{r_m}{a_o} \qquad \text{für } 0 \le x \le x_m$$

$$r(x) = \frac{r_m/a_1 - r_m}{x_1 - x_m} \cdot x + r_m \cdot \frac{x_1 - x_m/a_1}{x_1 - x_m} \qquad \text{für } x_m \le x \le x_1$$

$$r(x) = r_m/a_1 \qquad \text{für } x_1 \le x$$

Dabei ist $r_m$ der minimale Lochradius, $x_m$ der Abstand vom Mittelpunkt des Reaktors des Ortes der maximalen Sputterrate am Target, $x_1$ der Abstand vom Mittelpunkt des Reaktors des Randes der Substratscheibe, $a_o$ der Erniedrigungsfaktor der Sputterrate am Mittelpunkt des Reaktors relativ zur maximalen Sputterrate am Ort $x_m$ und $a_1$ der Erniedrigungsfaktor der Sputterrate am Rand der Substratscheibe relativ zur maximalen Sputterrate am Ort $x_m$.

Diese Verteilung der Lochradien berücksichtigt, daß in vielen Sputterreaktoren es einen Ort am Target gibt, an dem die Sputterrate maximal ist. Meist ist dieser Ort bei etwa zwei Drittel des Substratscheibenradius. Er hängt vom Reaktortyp ab und kann aus dem Errosionsprofil eines Sputtertargets nach längerer Standzeit bestimmt werden. Auch die Faktoren $a_o$ und $a_1$, um die die Sputterraten am Targetmittelpunkt bzw. am Scheibenrand relativ zur maximalen Sputterrate erniedrigt ist, können durch Ausmessen des Errosionsprofils bestimmt werden. Typische Werte in üblichen Reaktoren sind $a_o = 0,5$, $a_1 = 0,4$.

Der minimale Lochradius $r_m$ kann zum Beispiel so gewählt werden, daß das Aspektverhältnis $(2r_m)/d$ des Kollimators gleich dem Aspektverhältnis der kleinsten auf dem Wafer vorhandenen Strukturen, zum Beispiel Kontaktlöchern ist. Dabei ist d die Dicke des Kollimators. Der Scheibenradius $x_1$ hängt von der Größe der verwendeten Substratscheiben ab und beträgt zum Beispiel 100 mm.

Figur 4 zeigt einen Schnitt durch einen Kollimator, der in einer anderen Ausführungsform der Erfindung eingesetzt werden kann. Der Kollimator 6 weist Löcher 7 auf, die unterschiedliche Lochradien aufweisen und die durch Stege 8 unterschiedlicher Breite voneinander getrennt sind. Die vergrößerte Breite der Stege 8 führt zu einer lokalen Abschwächung der vertikalen Teilchenstromkomponente. Auf den Stegen 8 sind Abschattungsstege 9 angeordnet. Im Betrieb wird der Kollimator 6 so zwischen Sputtertarget und Substratscheibe angeordnet, daß die Abschattungsstege 9 in Richtung Sputtertarget ausgerichtet sind. Die Abschattungsstege 9 fangen beim Sputtern einen Teil der lateralen Teilchenstromkomponente ab. Die Abschattungsstege 9 bewirken daher, daß der Anteil der lateralen Teilchenstromkomponente, der sich an den Seitenwänden der Löcher 7 abscheidet, reduziert wird. Dadurch wird die Alterung des Kollimators 6 verlangsamt.

**Patentansprüche**

1. Verfahren zur Abscheidung einer Schicht auf einer Substratscheibe mit Hilfe eines Sputterprozesses,

   - bei dem die Substratscheibe (3) in einem Sputterreaktor (1) mit einem Target (2) und einem Kollimator (4) so angeordnet wird, daß der Kollimator (4) zwischen der Substratscheibe (3) und dem Target (2) angeordnet ist,

   - bei dem beim Sputtern eine vertikale und eine laterale Komponente im Teilchenstrom auftritt, wobei die vertikale Komponente über die Substratscheibe (3) inhomogen ist,

   - bei dem der Kollimator (4) mit zylindrischen Löchern (5) versehen ist, deren Zylinderachse im wesentlichen senkrecht zur Oberfläche der Substratscheibe (3) ausgerichtet ist und die im wesentlichen nur die vertikale Komponente des Teilchenstrom durchlassen,

   - bei dem der Kollimator (4) Locher (5) mit unterschiedlich großen Lochradien aufweist,

   - bei dem Lochradien in Bereichen des Sputterreaktors (1) mit höherer vertikaler Stromkomponente kleiner sind als in Bereichen des Sputterreaktors (1) mit kleinerer vertikaler Stromkomponente.

2. Verfahren nach Anspruch 1,

   - bei dem die Substratscheibe (3) so im Reaktor (1) positioniert wird, daß der Reaktormittelpunkt und der Scheibenmittelpunkt zusammenfallen,

- bei dem die Lochradien vom Mittelpunkt des Sputterreaktors (1) bis zum Ort maximaler Sputterrate am Target (2) stetig abnehmen und von diesem Ort bis zu einem dem Scheibenrand entsprechenden Abstand vom Mittelpunkt wieder zunehmen und außerhalb des Scheibenrands konstant sind.

3. Verfahren nach Anspruch 2,
bei dem die Lochradien $r(x)$ als Funktion des Abstands x vom Mittelpunkt des Sputterreaktors folgende Verteilung aufweisen:

$$r(x) = \frac{r_m - r_m/a_o}{x_m} \cdot x + \frac{r_m}{a_o} \qquad \text{für } 0 \leq x \leq x_m$$

$$r(x) = \frac{r_m/a_1 - r_m}{x_1 - x_m} \cdot x + r_m \cdot \frac{x_1 - x_m/a_1}{x_1 - x_m} \qquad \text{für } x_m \leq x \leq x_1$$

$$r(x) = r_m/a_1 \qquad \text{für } x_1 \leq x$$

mit

$r_m$: minimaler Lochradius
$x_m$: Abstand vom Mittelpunkt des Sputterreaktors des Ortes der maximalen Sputterrate am Target
$x_1$: Abstand vom Mittelpunkt des Sputterreaktors des Randes der Substratscheibe
$a_o$: Erniedrigungsfaktor der Sputterrate am Mittelpunkt des Reaktors relativ zur maximalen Sputterrate am Ort $x_m$
$a_1$: Erniedrigungsfaktor der Sputterrate am Rand der Substratscheibe relativ zur maximalen Sputterrate am Ort $x_m$.

4. Verfahren nach Anspruch 3,
bei dem $x_m$, $a_o$ und $a_1$ durch Ausmessen des Erosionsprofils eines Targets nach längerer Standzeit bestimmt werden.

5. Verfahren nach Anspruch 3 oder 4,

- bei dem gilt $x_m = b \cdot x_1$, wobei b kleiner/gleich 0,9 ist,
- bei dem $a_o$ zwischen 0,1 und 0,7 liegt,
- bei dem $a_1$ zwischen 0,1 und 0,7 liegt.

6. Verfahren nach einem der Ansprüche 3 bis 5,
bei dem der minimale Lochradius so gewählt wird, daß das Aspektverhältnis $(2r_m)/d$ des Kollimators im wesentlich gleich dem Aspektverhaltnis derjenigen Strukturen in der Oberfläche der Substratscheibe mit dem kleinsten Durchmesser ist, wobei d die Dicke des Kollimators ist.

7. Verfahren nach einem der Ansprüche 1 bis 6,
bei dem die Sputterrate in dem Sputterreaktor durch Anlegen eines Magnetfeldes so beeinflußt wird, daß die laterale Stromdichte homogen eingestellt wird.

8. Verfahren nach einem der Ansprüche 1 bis 7,
bei dem der Abstand benachbarter Locher auf dem Kollimator unterschiedlich groß ist.

9. Verfahren nach einem der Ansprüche 1 bis 8,

- bei dem auf dem Kollimator (6) zwischen benachbarten Löchern (7) jeweils ein Abschattungssteg (9) vorgesehen ist, der den Kollimator (6) in einer Ebene senkrecht zur Zylinderachse der Löcher (7) überragt,

- bei dem die Löcher (7) des Kollimators (6) jeweils ringförmig mit Abschattungsstegen (9) umgeben sind,

- bei dem der Kollimator (6) so angeordnet wird, daß die Abschattungsstege (9) zum Target hinweisen, so daß ein Teil der lateralen Stromkomponente von den Abschattungsstegen (9) abgefangen wird.

**Claims**

1. Method for depositing a layer on a substrate wafer using a sputtering process,

    - in which the substrate wafer (3) is arranged in a sputtering reactor (1) with a target (2) and a collimator (4) in such a way that the collimator (4) is arranged between the substrate wafer (3) and the target (2),
    - in which a vertical and a lateral component occurs in the particle flux during the sputtering, the vertical component being inhomogeneous over the substrate wafer (3),
    - in which the collimator (4) is provided with cylindrical holes (5) whose cylinder axis is aligned essentially perpendicular to the surface of the substrate wafer (3) and which transmit essentially only the vertical component of the particle flux,
    - in which the collimator (4) has holes (5) with different values of hole radius,
    - in which the hole radii in regions of the sputtering reactor (1) with higher vertical flux components are smaller than in regions of the sputtering reactor (1) with smaller vertical flux components.

2. Method according to Claim 1,

    - in which the substrate wafer (3) is positioned in the reactor (1) in such a way that the centre of the reactor and the centre of the wafer coincide,
    - in which the hole radii decrease constantly from the centre of the sputtering reactor (1) to the point of maximum sputtering rate on the target (2), and increase again from this point to a distance from the centre corresponding to the edge of the wafer, and are constant outside the edge of the wafer.

3. Method according to Claim 2, in which the hole radii r(x) have the following distribution as a function of the distance x from the centre of the sputtering reactor:

$$r(x) = \frac{r_m - r_m/a_0}{x_m} \cdot x + \frac{r_m}{a_0} \qquad \text{for } 0 \leq x \leq x_m$$

$$r(x) = \frac{r_m/a_1 - r_m}{x_1 - x_m} \cdot x + r_m \cdot \frac{x_1 - x_m/a_1}{x_1 - x_m} \qquad \text{for } x_m \leq x \leq x_1$$

$$r(x) = r_m/a_1 \qquad \text{for } x_1 \leq x$$

with

$r_m$: minimum hole radius
$x_m$: distance from the centre of the sputtering reactor to the point of maximum sputtering rate on the target
$x_1$: distance from the centre of the sputtering reactor to the edge of the substrate wafer
$a_0$: reduction factor for the sputtering rate at the centre of the reactor relative to the maximum sputtering reactor at the point $x_m$
$a_1$: reduction factor for the sputtering rate at the edge of the substrate wafer relative to the maximum sputtering rate at the point $x_m$.

4. Method according to Claim 3, in which $x_m$, $a_0$ and $a_1$ are determined by taking measurements of the erosion profile of a target after it has been used for a relatively long time.

5. Method according to Claim 3 or 4,

- in which $x_m = b \cdot x_1$, with b less than/equal to 0.9,
- in which $a_0$ is between 0.1 and 0.7,
- in which $a_1$ is between 0.1 and 0.7.

**6.** Method according to one of Claims 3 to 5, in which the minimum hole radius is chosen in such a way that the aspect ratio $(2r_m)/d$ of the collimator is essentially equal to the aspect ratio of those structures in the surface of the substrate wafer which have the smallest diameter, d being the thickness of the collimator.

**7.** Method according to one of Claims 1 to 6, in which the sputtering rate in the sputtering reactor is modified by applying a magnetic field in such a way that the lateral flux density is set homogeneously.

**8.** Method according to one of Claims 1 to 7, in which the distance between adjacent holes on the collimator takes different values.

**9.** Method according to one of Claims 1 to 8,

- in which a shade (9), which protrudes from the collimator (6) in a plane perpendicular to the cylinder axis of the holes (7), is provided between each pair of adjacent holes (7) on the collimator (6),
- in which the holes (7) of the collimator (6) are each annularly enclosed by shades (9),
- in which the collimator (6) is arranged in such a way that the shades (9) point towards the target, so that part of the lateral flux component is intercepted by the shades (9).

**Revendications**

**1.** Procédé pour le dépôt d'une couche sur un substrat en forme de disque à l'aide d'un procédé de pulvérisation,

- dans lequel le substrat en forme de disque (3) est situé dans un réacteur de pulvérisation (1) avec une cible (2) et un collimateur (4) de manière à ce que le collimateur (4) soit situé entre le substrat en forme de disque (3) et la cible (2),
- dans lequel il se produit, lors de la pulvérisation, une composante verticale et une composante latérale dans le courant de particules, la composante verticale étant non homogène sur le substrat en forme de disque (3),
- dans lequel le collimateur (4) est pourvu de trous cylindriques (5) dont l'axe est orienté de manière essentiellement perpendiculaire par rapport à la surface du substrat en forme de disque (3) et qui ne laissent passer, essentiellement, que la composante verticale du courant de particules,
- dans lequel le collimateur (4) est pourvu de trous (5) qui ont des rayons de grandeurs différentes,
- dans lequel les rayons des trous sont plus petits dans les zones du réacteur de pulvérisation (1) où la composante verticale du courant est plus élevée que dans les zones du réacteur de pulvérisation (1) où la composante verticale du courant est moins importante.

**2.** Procédé selon la revendication 1,

- dans lequel le substrat en forme de disque (3) est positionné dans le réacteur (1) de manière à ce que le centre du réacteur et le centre du disque coïncident,
- dans lequel les rayons des trous diminuent de manière continue depuis le centre du réacteur de pulvérisation (1) jusqu'à l'endroit où le taux de pulvérisation sur la cible (2) est maximal et augmentent à nouveau depuis cet endroit jusqu'à une distance du centre correspondant au bord du disque, et sont constants à l'extérieur du bord du disque.

**3.** Procédé selon la revendication 2,
dans lequel les rayons r(x) des trous, en tant que fonction de la distance x par rapport au centre du réacteur de pulvérisation, présentent la distribution suivante :

$$r(x) = \frac{r_m - r_m/a_0}{x_m} \cdot x + \frac{r_m}{a_0} \qquad \text{pour } 0 \leq x \leq x_m$$

$$r(x) = \frac{r_m/a_1 - r_m}{x_1 - x_m} \cdot x + r_m \cdot \frac{x_1 - x_m/a_1}{x_1 - x_m} \qquad \text{pour } x_m \le x \le x_1$$

$$r(x) = r_m/a_1 \qquad \text{for } x_1 \le x$$

avec

$r_m$ : rayon minimum des trous

$x_m$ : distance par rapport au centre du réacteur de pulvérisation de l'endroit où le taux de pulvérisation sur la cible est maximal

$x_1$ : distance par rapport au centre du réacteur de pulvérisation du bord du substrat en forme de disque

$a_0$ : facteur de réduction du taux de pulvérisation au centre du réacteur par rapport au taux de pulvérisation maximum à l'endroit $x_m$

$a_1$ : facteur de réduction du taux de pulvérisation au niveau du bord du substrat en forme de disque par rapport au taux de pulvérisation maximum à l'endroit $x_m$.

4. Procédé selon la revendication 3,
   dans lequel $x_m$, $a_0$ et $a_1$ sont déterminés en mesurant le profil d'érosion d'une cible après un temps d'utilisation assez long.

5. Procédé selon l'une des revendications 3 ou 4,

   - dans lequel $x_m = b \cdot x_1$, b étant inférieur ou égal à 0,9
   - dans lequel $a_0$ est compris entre 0,1 et 0,7,
   - dans lequel $a_1$ est compris entre 0,1 et 0,7.

6. Procédé selon l'une des revendications 3 à 5,
   dans lequel le rayon minimum des trous est choisi de manière à ce que le rapport d'aspect $(2r_m)/d$ du collimateur soit essentiellement égal au rapport d'aspect des structures de la surface du substrat en forme de disque qui ont le plus petit diamètre, d étant l'épaisseur du collimateur.

7. Procédé selon l'une des revendications 1 à 6,
   dans lequel le taux de pulvérisation dans le réacteur de pulvérisation est influencé par l'application d'un champ magnétique de manière à ce que la densité du courant latérale soit réglée pour être homogène.

8. Procédé selon l'une des revendications 1 à 7,
   dans lequel la distance entre des trous contigus sur le collimateur diffère.

9. Procédé selon l'une des revendications 1 à 8,

   - dans lequel on prévoit à chaque fois, sur le collimateur (6), entre des trous contigus (7), un élément intermédiaire d'atténuation (9) qui dépasse le collimateur (6) dans un plan perpendiculaire par rapport à l'axe des cylindres des trous (7),
   - dans lequel les trous (7) du collimateur (6) sont entourés à chaque fois de manière annulaire par des éléments intermédiaires d'atténuation (9),
   - dans lequel le collimateur (6) est situé de manière à ce que les éléments intermédiaires d'atténuation (9) soient dirigés vers la cible, de façon à ce qu'une partie de la composante latérale du courant soit interceptée par les éléments intermédiaires d'atténuation (9).

FIG 1

FIG 2

## FIG 3

## FIG 4